Europäisches Patentamt

European Patent Office

Office européen des brevets

(11) Publication number: **0 517 208 A1**

# EUROPEAN PATENT APPLICATION

(21) Application number: **92109448.8**

(22) Date of filing: **04.06.92**

(51) Int. Cl.⁵: **H01L 27/146**

(30) Priority: **05.06.91 JP 162065/91**
**13.06.91 JP 168799/91**

(43) Date of publication of application:
**09.12.92 Bulletin 92/50**

(84) Designated Contracting States:
**DE FR GB IT NL SE**

(71) Applicant: **KANEGAFUCHI KAGAKU KOGYO
KABUSHIKI KAISHA
2-4 Nakanoshima 3-chome**

**Kita-ku Osaka-shi Osaka 530(JP)**

(72) Inventor: **Kobayashi, Kenji
24-8-303, Konookacho
Otsu-shi, Shiga(JP)**

(74) Representative: **Bühling, Gerhard, Dipl.-Chem.
Patentanwaltsbüro Tiedtke-Bühling-Kinne &
Partner, Bavariaring 4
W-8000 München 2(DE)**

(54) Semiconductor device and method of manufacturing the same.

(57) The invention concerns a semiconductor device, which comprises an insulating substrate, semiconductor elements, electrodes connected thereto via an inter-layer insulating film and an insulating protective film, permits semiconductor element sections and electrode sections to be free from leaks and electrode to be free from corrosion and connection resistance to have stable even under high temperature, high relative humidity conditions and ensures enhanced electrode adhesion to provide for improved wire bonding performance, and also a method of manufacturing the same.

An inter-layer insulating film 34 covering an insulating substrate 12 is etched to remove only its portions corresponding to contact sections 36, 38, 40 and 42 necessary for connection to external parts. An insulating protective film 50 covering the insulating film 12 is etched to remove only electrode pad sections 28 necessary for connection to external parts. The inter-layer insulating film 34 and/or insulating protective film 50 are patterned such as to cover a marginal portion of electrode pad sections 28.

Fig. 1

## BACKGROUND OF THE INVENTION

This invention relates to semiconductor devices and a method of manufacturing the same and, more particularly, to semiconductor devices used for facsimile systems, image readers, digital scanners and so forth and a method of manufacturing the same.

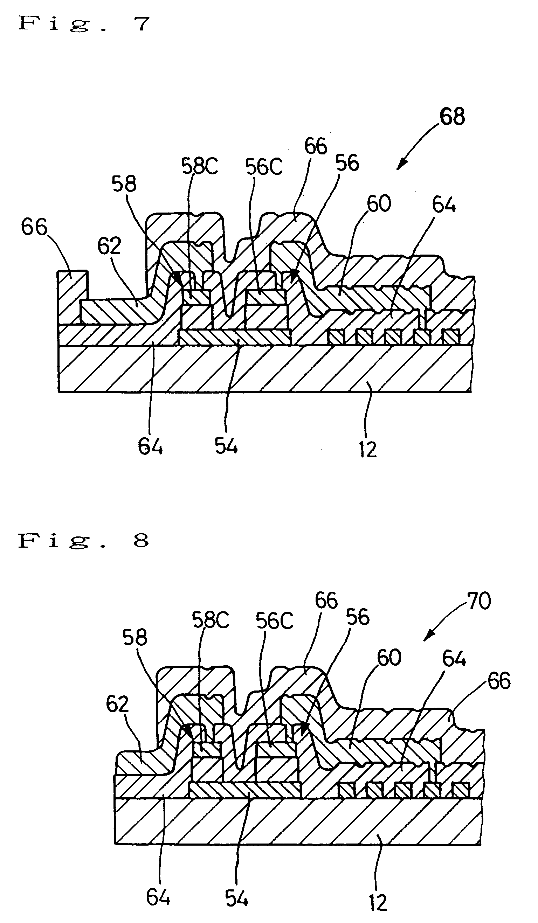

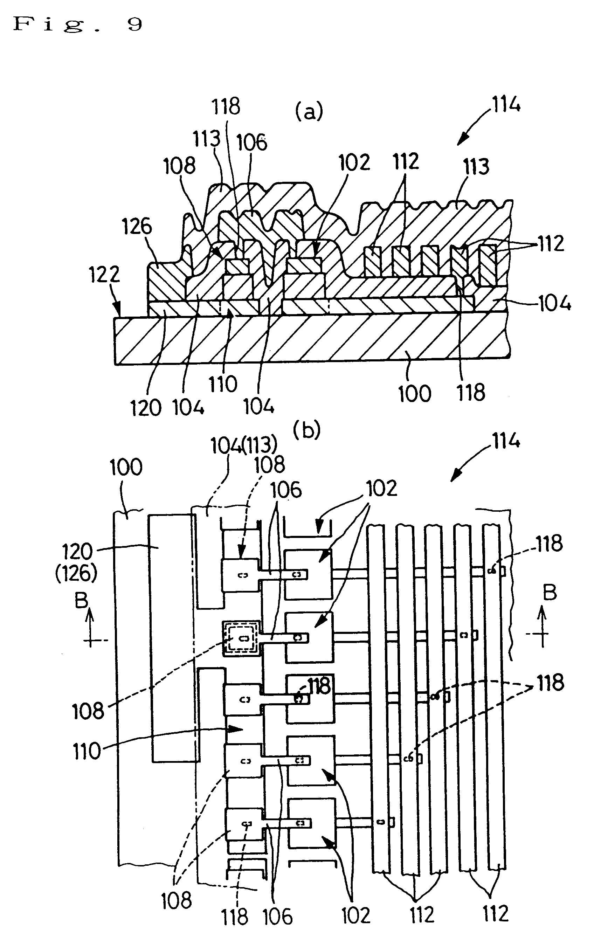

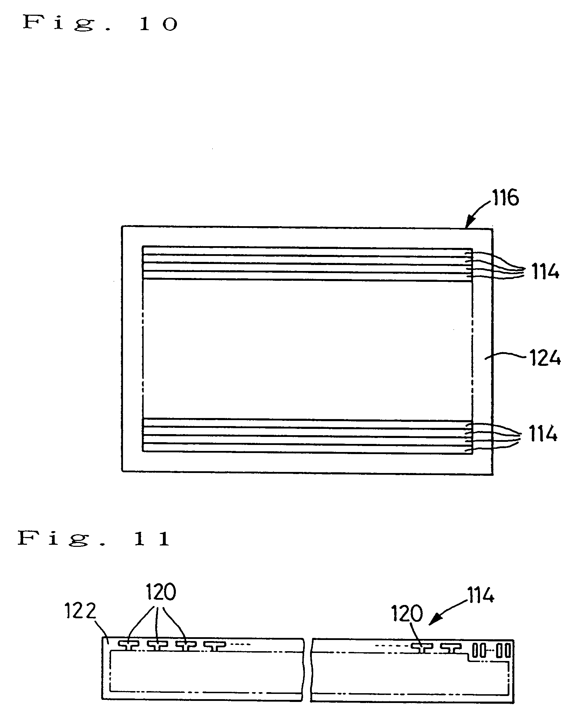

Semiconductor devices provided heretofore are of various structures. Figs. 9(a) and 9(b) show an example of such semiconductor device 114. This semiconductor device comprises a glass substrate 100, which is provided with a large number of photo-diodes 102 arranged uni-dimensionally, blocking diodes 108 each isolated via an inter-layer insulating film 104 from and connected by opposite polarity, series connection by a connection electrode 106 to each of the photo-diodes 102, common electrodes 110 each for driving each block comprising a predetermined number of photo-diodes 102 and associated blocking diodes 108, matrix leads 112 for reading out signal from driven photo-diodes 102, and an insulating protective film 113 covering and insulating the photodiodes 102 and other elements. In actual practice, a plurality of such semiconductor devices 114 are formed simultaneously on a large area glass substrate 116 as shown in Fig. 10 and are then cut into individual semiconductor devices as shown in Fig. 11.

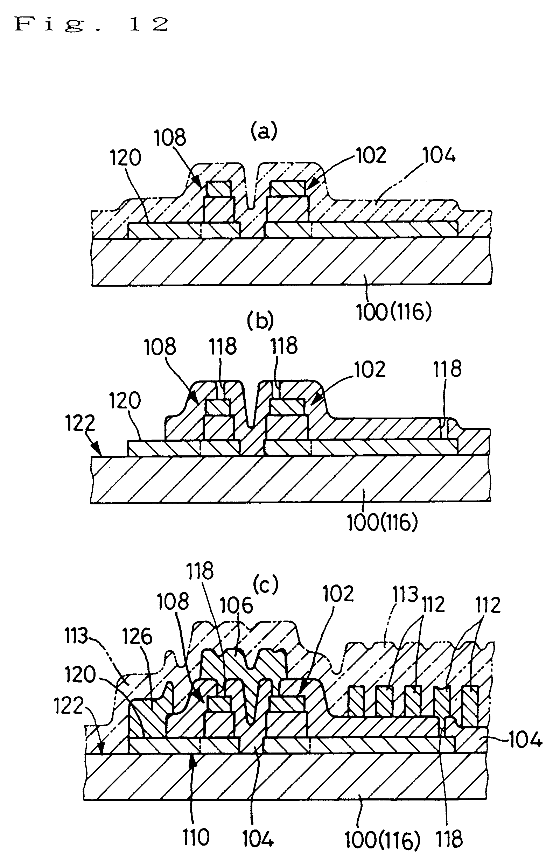

Figs. 12(a) to 12(c) illustrate a method of manufacturing this semiconductor device 114. In manufacture, uni-dimensional arrays of pluralities of photo-diodes 102 and blocking diodes 108 are formed on large area glass substrate 116. Then, inter-layer insulating film 104 is formed over the entire area of the glass substrate 116 to cover the diodes. The insulating film 104 is then etched by means of reactive ion etching (RIE) to form a plurality of contact holes 118 and also remove its portion corresponding to signal input/output electrode pads 120 and also to a marginal portion 122 of the semiconductor device 114 including the pads 120 (see Fig. 11) as well as to a marginal portion 124 of the glass substrate 116 not constituting the semiconductor device 114 (see Fig. 10). Subsequently, connection electrodes 106 and matrix leads 112 are formed to fill the contact holes 118 that have been formed by removing the inter-layer insulating film 104, while forming outer take-out electrodes 126 on the electrode pads 120. Thereafter, an insulating protective film 113 is formed over the entire area of glass substrate 116 provided with the individual elements of the semiconductor device 114, and then etched by reactive ion etching to remove its portion corresponding to marginal portion 122, 124 including the electrode pads 120. In this way, the semiconductor device 114 shown in Fig. 9 is obtained.

In the above process of manufacturing the semiconductor device 114, the inter-layer insulating film 104 is formed over the entire area of the large area glass substrate 116. Therefore, removing the inter-layer insulating film 104 by means of reactive ion etching (RIE) from a broad area of the glass substrate 116 exclusive of portions corresponding to the semiconductor device elements 102 and 108 and matrix leads 112, results in great sputtering of not only component of the inter-layer insulating film 104 but also component of the glass substrate 116. That is, the portion of the inter-layer insulating film 104 that is to be removed by means of reactive ion etching is mostly formed directly on the glass substrate 116. The inter-layer insulating film 104 is composed of SiOx and so forth, while the glass substrate 116 is principally composed of Si, and the gas for dry etching to remove the inter-layer insulating film 104 reacts as well with Si of the glass substrate 116, thus causing the sputtering of a great amount of the component of the glass substrate 116. This component of the glass substrate 116 sputtered in a great amount is finely deposited again over the entire area of the glass substrate 116.

The re-deposited components of the inter-layer insulating film 104 and glass substrate 116 reduce the adhesion or increase the connection resistance of the outer take-out electrodes 126 formed on the electrode pads 120 and connection electrodes 106 formed in the contact holes 118, thus deteriorating the wire bonding performance or sensor performance. In addition, the surface of the glass substrate 116 is damaged by dry etching to become irregular and white, thus making it difficult to position photo-mask in patterning the connection electrodes 106 and matrix leads 112.

The same problem is posed with the insulating protective film 113. The insulating protective film 113 is formed over the entire area of the semiconductor device 114, and its marginal portion exclusive of portions corresponding to the semiconductor device elements 102 and 108 and matrix leads 112 is then etched by means of reactive ion etching(RIE). The insulating protective film 113 comprises SiOx, SiNx, etc. principally composed of Si, while the glass substrate 116 is principally composed of Si, and the gas for dry etching to remove the insulating protective film 113 also reacts with Si of the glass substrate 116 to cause sputtering of a great amount of the component of the glass substrate 116. The component of the glass substrate 116 thus sputtered in a great amount, is finely re-deposited on the entire area of the glass substrate 116, particularly, on the electrode pad areas 120 (106) exposed after removal of the insulating protective film 113, thus deteriorating the wire bonding performance of the electrode pads 120 or increasing the connection resistance.

In a further aspect, as the edge of the resultant insulating protective film 113 formed over the semiconductor device 114 is close to the inner semiconductor device elements 102 and 108 and matrix leads 112, moisture is liable to intrude through the edge of the insulating protective layer 113 and cause leaks in the semiconductor device elements 102 and 108 or corrosion of the metal lead electrodes. In addition, the boundary portion of the glass substrate 116 provided with the signal input/output electrode pads 120 is exposed to atmosphere. Therefore, moisture is liable to intrude into the interface between the electrode pads 120 and glass substrate 116 and also the interface between the electrode pads 120 and outer take-out electrodes 126 formed thereon. This poses a problem of causing corrosion of the electrode pads 120.

BRIEF SUMMARY

The inventor has conducted extensive researches and investigations in order to solve the above problems, thus attaining the present invention. An object of the invention is to provide a semiconductor device, which comprises on an insulating substrate, semiconductor elements, electrodes connected thereto via an inter-layer insulating film and an insulating protective film, permits semiconductor element sections and electrode sections to be free from leaks and electrode to be free from corrosion and connection resistance to have stable even under high temperature, high relative humidity conditions and ensures enhanced electrode adhesion to provide for improved wire bonding performance.

A subject matter of the invention is to provide a semiconductor device, which comprises an insulating substrate, a semiconductor element formed on an insulating substrate and constituted by a lamination of an inner electrode formed on an insulating substrate, a semiconductor layer and an outer electrode, an inter-layer insulating film covering at least the semiconductor element and a connection electrode provided via the inter-layer insulating film, the inter-layer insulating film being formed on the entire area of the insulating substrate except for contact sections for connection to external parts.

In this semiconductor device, the contact sections include an electrode pad section contiguous to the lower electrode of the semiconductor element, the electrode pad section having at least a marginal portion covered by the inter-layer insulating film.

Another subject matter of the invention is to provide a semiconductor device, which comprises an insulating substrate, a semiconductor element formed on the insulating substrate and constituted by a lamination of an inner electrode a semicoductor layer and an outer electrode, an inter-layer insulating film covering at least the semiconductor element, a connection electrode provided via the inter-layer insulating film and an insulating protective film covering the constituent elements on the insulating substrate, the insulating protective film being formed over the entire area of the insulating substrate except for a signal input/output electrode pad section.

In this semiconductor device, the inter-layer insulating film is formed on the entire area of the insulating substrate except for contact sections for connection to external parts.

In addition, in the above semiconductor device the signal input/output electrode pad section has at least a marginal portion covered by the insulating protective film.

Further, in the above semiconductor device the contact sections include an electrode pad section contiguous to the lower electrode of the semiconductor element, the electrode pad section having at least a marginal portion covered by the inter-layer insulating film.

A further subject matter of the invention is to provide a method of manufacturing a semiconductor device, which comprises an insulating substrate, a semiconductor element formed on the insulating substrate and constituted by a lamination of an inner electrode, a semiconductor layer and an outer electrode, an inter-layer insulating film covering at least the semiconductor element and a connection electrode provided via the inter-layer insulating film, the method comprising covering the entire area of the insulating substrate with the inter-layer insulating film and removing portions of the inter-layer insulating film corresponding to the contact sections for connection to external parts.

A still further subject matter of the invention is to provide a method of manufacturing a semiconductor device, which comprises an insulating substrate, a semiconductor element formed on the insulating substrate and constituted by a Lamination of an inner electrode, a semiconductor layer and an outer electrode, an inter-layer insulating film covering at least the semiconductor element, a connection electrode provided via the inter-layer insulating film and an insulating protective film covering the constituent elements on the insulating substrate, the method of comprising covering the entire area of the insulating substrate with the insulating protective film and then removing a portion of the insulating protective film corresponding to the signal input/output electrode pad section.

In this method of manufacturing a semiconductor device, after covering the entire area of the insulating substrate with the inter-layer insulating film, portions of the inter-layer insulating film corresponding to the contact sections for connection to external parts are removed.

With the semiconductor device according to the invention, only portions of the inter-layer insulating film corresponding to the contact sections necessary for connection to external parts, i.e., electrode pad and contact holes, are removed, and the remainder of the inter-layer insulating film covers the remaining area of the insulating substrate. In the method of manufacture of the semiconductor device having this structure, only portions of the inter-layer insulating film covering the semiconductor element corresponding to the contact sections on electrodes are etched away. Thus, there is substantially no possibility of causing the sputtering of component of the substrate as the insulating substrate such as a glass substrate is etched.

That is, component that is sputtered from the inter-layer insulating film being etched is very slight, and substantially no sputtered component is re-deposited on electrodes or the like. Thus, outer take-out electrodes and connection electrodes formed on the inter-layer insulating film after formation of the contact holes, are firmly connected to inner electrodes and outer electrodes of semiconductor element through the contact holes. It is thus possible to eliminate increase of the connection resistance and deterioration of the wire bonding performance. In addition, the glass substrate surface is not etched, and therefore there is no possibility for the surface to become white, thus permitting ready photo-mask positioning in the next step and permitting manufacture of a semiconductor device having a more excellent quality. Further, since the inter-layer insulating film is not etched except for the necessary portions, i.e., portions corresponding to the contact sections, it is possible to hold a substantially fixed attaching atmosphere at all times, thus permitting uniform and quick etching of the inter-layer insulating film.

Further, with the inter-layer insulating film patterned to cover a marginal portion of the electrode pad section for the inner electrode, it is possible to improve the moisture resistance of the electrode pad section marginal portion, thus preventing leaks.

Further, with the semiconductor device according to the invention only portions of the insulating protective film corresponding to electrode pad sections necessary for connection to external parts are removed, and the remainder of the insulating protective film covers the remaining area of the insulating substrate. Thus, sufficiently long distances are ensured from the semiconductor element sections and matrix lead sections to the borderline, i.e., end, of the insulating protective film covering the insulating substrate. That is, there is no possibility of leaks or corrosion of metal electrodes that may otherwise be caused by moisture intrusion through the interface between the insulating protective film and insulating substrate.

Further, in the method of manufacturing a semiconductor device having the above structure, only portions of the insulating protective film covering semiconductor elements and so forth are etched away, which correspond to the electrode pad sections. Thus, there is no possibility of etching and sputtering the insulating substrate consisting of a glass substrate or the like. There is thus no possibility of re-deposition of any sputtered component on the electrode pad sections, thus eliminating deterioration of the wire bonding performance or increase of the connection resistance.

Further, in the method of manufacturing a semiconductor device as above, only portions of the insulating substrate covering the inter-layer insulating film that correspond to the contact sections such as electrode pads and contact holes are etched away. Thus, there is no possibility of etching and sputtering the component of the insulating substrate, that is, there is no possibility of re-deposition of any sputtered component on the electrode sections and so forth. Thus, the outer take-out electrodes and connection electrodes that are formed after formation of the inter-layer insulating film, are firmly connected to the inner electrodes and outer electrodes of the semiconductor elements, and there is no possibility of increase of the connection resistance or deterioration of the wire bonding performance. Further, since the surface of the insulating substrate is not etched, the is no possibility for the surface to become white, thus permitting ready photo-mask positioning in the next step and permitting manufacture of a semiconductor device having a more excellent quality. Further, since no other portion of the inter-layer insulating film than those corresponding to the contact sections is etched away, it is possible to maintain substantially a constant etching atmosphere at all times and thus permit substantially uniform and quick etching of the inter-layer insulating film.

Further, with the insulating protective film patterned such as to cover a marginal portion of the outer take-out electrode on the electrode pad section, it is possible to improve the moisture resistance of a marginal portion of the electrode pad section and prevent leaks and corrosion.

As shown, with the semiconductor device and the method of manufacturing the same according to the invention, other portion of the inter-layer insulating film covering the semiconductor element than those corresponding to contact sections such as pores for connection to external parts and contact holes is not etched away when patterning the interlayer insulating film. Thus, it is possible to suppress sputtered component of the glass substrate or the like during etching and eliminate re-deposition of any sputtered component. The outer take-out electrodes and connection electrodes that are formed in the electrode pad sections and contact holes formed by removal of the inter-layer insulating film, are firmly attached, and there is no possibility of increase of the connection resistance or deterioration of the wire bonding performance. Further, since no other portion of the inter-layer insulating film and the like than required is etched away, it is possible to hold substantially a constant etching atmosphere and effect more uniform and quicker etching.

Further, by permitting etching of the inter-layer insulating film such as to cover at least a marginal portion of electrode pad section, it is possible to improve the moisture resistance of the electrode pad section, suppress leaks in the semiconductor element section and thus provide a semiconductor device having a stable quality.

Further, with the other semiconductor device and method of manufacturing the same according to the invention, the insulating protective film for protecting the semiconductor device is formed over the entire area of the insulating substrate except for the signal input/output electrode pad section. Thus, sufficiently large distances can be provided from the edge of the interface between the insulating protective film and the insulating substrate to the internal semiconductor element and leads. It is thus possible to prevent intrusion of moisture, thus substantially eliminating the possibility of leaks in the semiconductor element and the like or corrosion of electrodes. Further, with the insulating protective film patterned such as to cover a marginal portion of the electrode pad section, the borderline of the electrode pad section formed on the insulating substrate is protected by the insulating protective film and not exposed to atmosphere, thus preventing corrosion of the electrode pad section and also preventing intrusion of moisture through the borderline.

Further, while forming the insulating protective film such as to protect the entire area of the insulating substrate except for the electrode pad section, the inter-layer insulating film covering at least the semiconductor element is etched to form the contact sections such as pores necessary for connection to external parts and contact holes such as not to etch away its portion other than those corresponding to the contact sections. Thus, no component of the insulating substrate is sputtered by etching, and there is no possibility of re-deposition of any sputtered component. Thus, outer take-out electrodes and connection electrodes formed on the electrode pad section and in the contact holes after the patterning of the inter-layer insulating film, are firmly attached, and there is no possibility of increase of the connection resistance or deterioration of the wire bonding performance. Further, since no other portion of the inter-layer insulating film than required is etched, it is possible to hold a substantially constant etching atmosphere and effect more uniform and quicker etching. Besides, the inter-layer insulating film prevents intrusion of moisture, thus substantially eliminating leaks or corrosion.

As shown above, according to the invention it is possible to provide a semiconductor device, which can eliminate leaks or corrosion in semiconductor element sections and electrode sections and is very stable and reliable even under high temperature, high relative humidity conditions.

BRIEF DESCRIPTION OF THE DRAWINGS

Figs. 1(a) and 1(b) illustrate an embodiment Of the semiconductor device according to the invention, with Fig. 1(a) being a sectional view taken along line A-A in Fig. 1(b), and Fig. 1(b) being a fragmentary plane view;

Figs. 2(a) to 2(d) illustrate a process of manufacture of the semiconductor device shown in Fig. 1(a), with Fig. 2(a) being a view showing an insulating substrate and a metal film formed thereon, Fig. 2(b) being a view showing the metal film after patterning, Fig. 2(c) being a view showing the substrate after formation of a semiconductor layer, and Fig. 2(d) being a view showing the after formation of an outer electrode layer;

Figs. 3(a) to 3(d) illustrate a subsequent process to the process of manufacture of the semiconductor device shown in Figs. 2(a) to 2(d), with Fig. 3(a) being a view showing the substrate after patterning of the outer electrode layer, Fig. 3(b) being a view showing the substrate after patterning of a semiconductor layer, Fig. 3(c) being a view showing the substrate with contact sections formed after formation of an inter-layer insulating film, and Fig. 3(d) being a view showing the substrate after formation of outer take-out electrode, connection electrode and matrix leads;

Figs. 4(a) and 4(b) illustrate an embodiment of the semiconductor device according to the invention, with Fig. 4(a) being a sectional view taken along line A-A in Fig. 4(b), and Fig. 4(b) being a fragmentary plane view;

Fig. 5 is a fragmentary sectional view showing a different embodiment of the semiconductor device according to the invention;

Fig. 6 is a fragmentary sectional view showing a further embodiment of the semiconductor device according to the invention;

Fig. 7 is a fragmentary sectional view showing a still further embodiment of the semiconductor device according to the invention;

Fig. 8 is a fragmentary sectional view showing a yet further embodiment of the semiconductor device according to the invention;

Figs. 9(a) and 9(b) illustrate a prior art semiconductor device, with Fig. 9(a) being a sectional view taken along line B-B in Fig. 9(b), and Fig. 9(b) being a fragmentary plane view;

Fig. 10 is a plane view showing a large area insulating substrate used for the method of semiconductor device manufacture;

Fig. 11 is a plane view, partly broken away, showing the entirety of prior art semiconductor device; and

Figs. 12(a) to 12(c) are fragmentary sectional views illustrating a prior art method of manufacturing a semiconductor device, with Fig. 12(a) being a view showing the substrate after formation of an inter-layer insulating film, Fig. 12(b) being a view showing the substrate after patterning of the inter-layer insulating film, and Fig. 12-(c) being a view showing the substrate with a protective film formed after electrode formation.

## DETAILED DESCRIPTION OF THE INVENTION

Now, the semiconductor device and method of manufacturing the same embodying the invention will be described in detail with reference to the drawings.

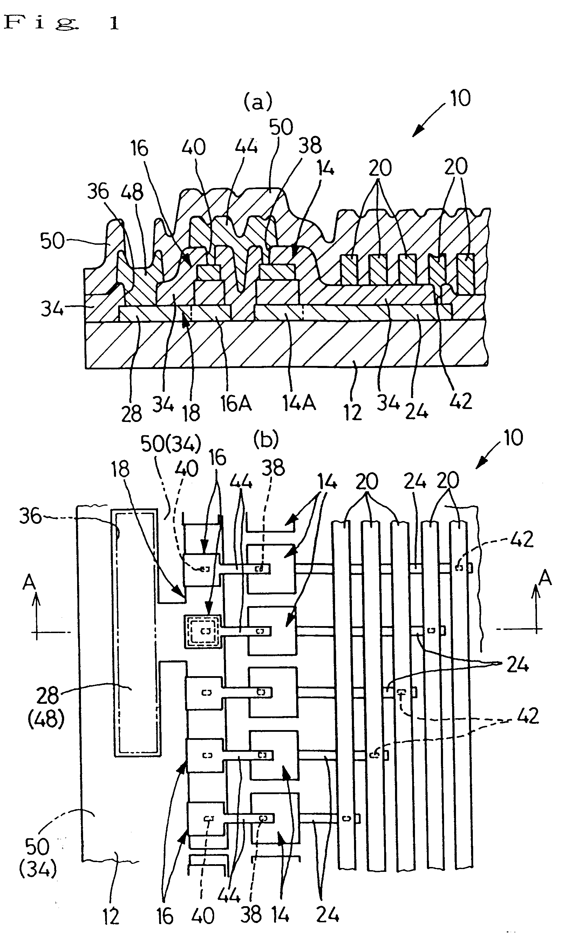

Figs. 1(a) and 1(b) show an embodiment of the semiconductor device. The semiconductor device 10 comprises an insulating substrate 12 of glass or the like. A plurality of photo-diodes 14 as semiconductor elements are formed in a uni-dimensional array on the substrate. Also, blocking diodes 16 individually associated with the respective photo-diodes 14 are formed in a uni-dimensional array. Each photo-diode 14 and the associated blocking diode 16 are connected to each other in opposite polarity series connection. The blocking diodes 16 are divided into a plurality of blocks each of a predetermined number of them, and common electrodes 18 are provided each for simultaneously driving the blocking diodes 16 in each group. On the side of the phot-diodes 14, matrix leads 20 are provided for taking out individual signals read out from simultaneously driven photo-diodes 14 in each group. The semiconductor device 10 having the above structure is manufactured in the following process.

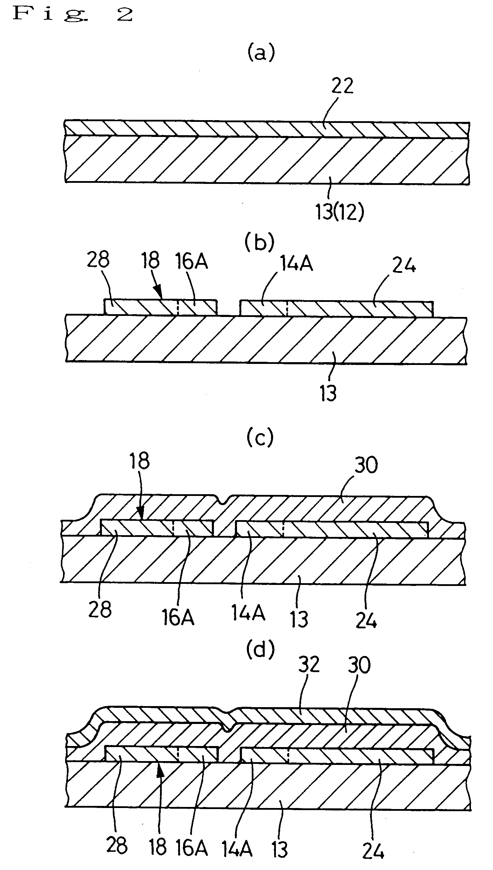

As shown in Fig. 2(a), on a large area insulating substrate 13 (12), which permits production of a plurality of semiconductor devices 10, a metal film 22 of chromium or the like is formed by means of sputtering or vacuum evaporation. Then, as shown in Fig. 2(b) the metal film 22 is photo-etched to a predetermined pattern to form inner electrodes 14A and 16A of photo- and blocking diodes 14 and 16, a lead electrode 24 integral with each inner electrode 14A and a common electrode 18 integral with each inner electrode 16A. The common electrode 18 is common to blocking diodes 16 in each block, and an electrode pad 28 is provided for each common electrode 18. In the process of photo-etching the metal layer 22, the surface of the insulating substrate 13 is not damaged.

Then, as shown in Figs. 2(c) and 2(d), an amorphous silicon type semiconductor layer 30 and a transparent electrode layer 32 are formed in the mentioned order on the insulating substrate 13 inclusive of the patterned inner electrodes 14A and 16A. In the structure of this embodiment, the amorphous silicon type semiconductor layer 30 is formed by forming layers of p-type a-SiC, i-type a-Si and n-type a-Si in the mentioned order by using a plasma CVD process. The transparent electrode layer 32 is formed by depositing ITO, $SnO_2$, etc. by means of sputtering or vacuum evaporation.

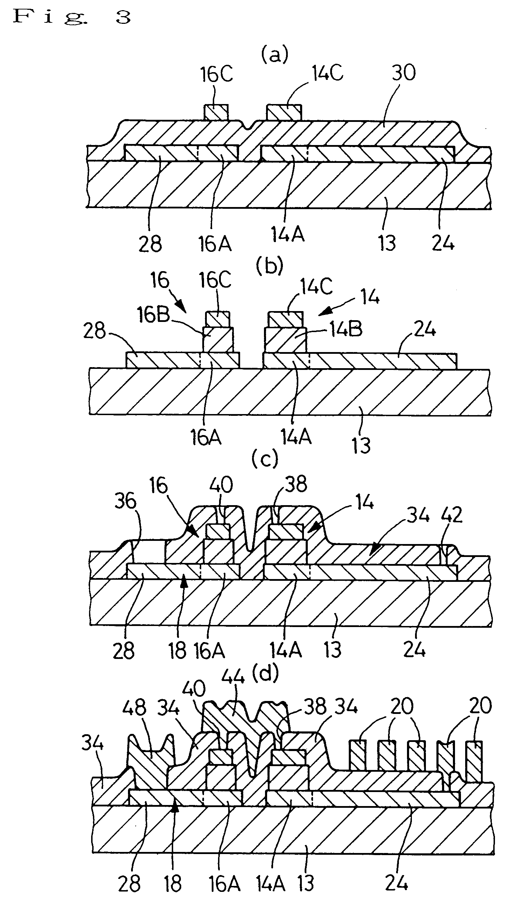

Then, as shown in Fig. 3(a) and 3(b), the amorphous silicon type semiconductor layer 30 and transparent electrode layer 32 formed on the insulating substrate 13 are patterned to a predetermined pattern by photo-etching process and reactive ion etching process in the reverse order. As a result, pluralities of the outer electrodes 14C and 16C on the respective semiconductor layer portions 14B and 16B are formed in uni-dimensional arrays. The inner electrodes 14A and 16A, semiconductor layer portions 14B and 16B, outer electrodes 14C and 16C constitute the photo- and blocking diodes 14 and 16.

Then, as shown in Fig. 3(c), a transparent inter-layer insulating film 34 such as a silicon oxide film, is formed by the plasma CVD process over the entire area of the insulating substrate 13 provided with the photo- and blocking diodes 14 and 16, and then it is formed with contact sections necessary for connection to external parts using the reactive ion etching (RIE) process. The contact sections are pores or openings 36 formed on electrode pad sections 28 of common electrodes 18, contact holes 38 and 40 for connecting the outer electrodes 14C of the photo-diodes 14 and the outer electrodes 16C of the blocking diodes 16 and contact holes 42 for taking out read signals from the inner electrodes 14A of the photo-diodes 14. Other portion of the inter-layer insulating film 34 than those corresponding to the contact sections is not etched.

Thus, the inter-layer insulating film 34 is etched for less area, under the contact sections are found the lead electrodes 24 of the inner electrodes 14A and 16A, electrode pads 28 and outer electrodes 14C and 16C, these not containing Si and and not being etched any reactive ions, and the insulating substrate 13 is not etched. Thus, it is possible to hold a substantially constant etching atmosphere and effect quick etching. In addition, substantially no component of the glass substrate 13 is sputtered by etching, and thus there is substantially no possibility of re-deposition of sputtered component on the electrode pads 28 and so forth. Further, the opening 36 provided on the electrode pad 28 of the common electrode 18 is patterned to be smaller than the contour of the electrode pad 28, as shown by a phantom line in Fig. 1(b) so that the insulating substrate 13 will not be exposed by the inter-layer insulating film 34. Thus, it is possible to provide enhanced moisture resistance of the inner electrodes 16A, thus permitting suppression of leaks and provision of a semiconductor device 10 having excellent performance.

After forming the openings 36 and contact holes 38, 40 and 42 in the inter-layer insulating film 34, a metal film is formed on the substrate by means of sputtering or vacuum evaporation and etched to a predetermined pattern, thus forming connection electrodes 44, matrix leads 20 and outer take-out electrodes 48, as shown in Fig. 3(d). The metal film may be a single layer of chromium (Cr), for instance, or it may have a double-layer structure of chromium and aluminum. Where the metal film consists of two or more layers, the innermost layer is suitably formed by selecting a material, which can provide satisfactory adhesion to the outer electrodes 14C and 16C as transparent electrodes and can also be difficult to react with the outer electrodes 14C and 16C, while for the outermost layer a material having a satisfactory wire bonding character is suitably selected.

After the above process, an insulating protective film 50 is finally formed over the entire area of the glass substrate 13 by the plasma CVD process, as shown in Fig. 1(a), and etched by means of reactive ion etching to expose only the electrode pads 28 for connection to external parts, thus obtaining the semiconductor device 10. The insulating protective film 50 is etched to cover a marginal portion of the outer take-out electrodes 48 formed in the pores 36 on the electrode pads 28 to prevent intrusion of moisture through the interface between the insulating protective film 50 and outer take-out electrode 48 or between the outer take-out electrode 48 and inter-layer insulating film 34. As the insulating protective film 50 silicon nitride or the like is formed a transparent protective film comprising insulator. The insulating protective film 50 is removed only for its areas corresponding to the electrode pads 28 with the outer take-out electrodes 48 formed thereon. Thus, when etching the insulating protective film 50, the glass substrate 13 is not etched, and thus there is no possibility of re-deposition of any sputtered component on the electrode pads 28. In practice, a plurality of semiconductor devices 10 are formed on the large area glass substrate 13, and they are individually cut out. Thus, each semiconductor device 10 comprises the cut glass substrate 12.

In this semiconductor device 10, the entire area of the glass substrate 12 (13) except for the area corresponding to the electrode pad 28 is covered by the insulating protective film 50, and sufficient distances are ensured from the edge of the interface between the glass substrate 12 and insulating protective film 50 to the internal semiconductor elements 14 and 16 and matrix leads 20. Thus, there is substantially no possibility for the device to be intruded by moisture, thus substantially eliminating the generation of leaks or corrosion of the metal electrodes due to intrusion of moisture. In addition, no component of the glass substrate 13 is sputtered at the time of etching the insulating protective film 50, thus eliminating the possibility of re-deposition of any substrate component on the electrode pad 28, that is, eliminating the possibility of deterioration of the wire bonding property of the electrode pad 28. It is thus possible to obtain yield improvement and quality stabilization of the semiconductor device 10.

Further, in the above embodiment of the method of manufacturing the semiconductor device 10, no other portion of the inter-layer insulating film 34 than those corresponding to the contact sections 36, 38, 40 and 42 is etched, thus suppressing the sputtering of the component of the glass substrate 13 and re-deposition of any sputtered component. Thus, the outer take-out electrode 48, connection electrode 44 and matrix leads 20 formed on the layer 34 are firmly connected to their respective inner electrodes. With the semiconductor device 10 thus obtained, there is thus no possibility of weakening of the adhesion or increase of the connection resistance of the outer take-out electrode 48 and so forth, and it is possible to ensure stable electric performance and excellent wire bonding property.

Using the above embodiment of the method, many samples of the semiconductor device 10 having the configuration shown in Figs. 1(a) and 1-(b) were produced, and it was confirmed that randomly taken-out 100 of these samples were free from bit defect. On these samples, a high temperature, high relative humidity acceleration test was conducted under conditions of 85°C and 85 % R.H. Leak bit generation was found in only one of the 100 samples. For comparison, many samples of the semiconductor device shown in Fig. 9 were produced, and on 100 of these samples a high temperature, high relative humidity acceleration test was conducted under the same conditions. Leak bit generation was found in 18 of the 100 samples. It will be seen from the above test results that the semiconductor device 10 according to the invention is very stable in reliability under high temperature, high relative humidity conditions.

While an embodiment of the invention has been described in detail, the invention may be practiced in various other forms as well.

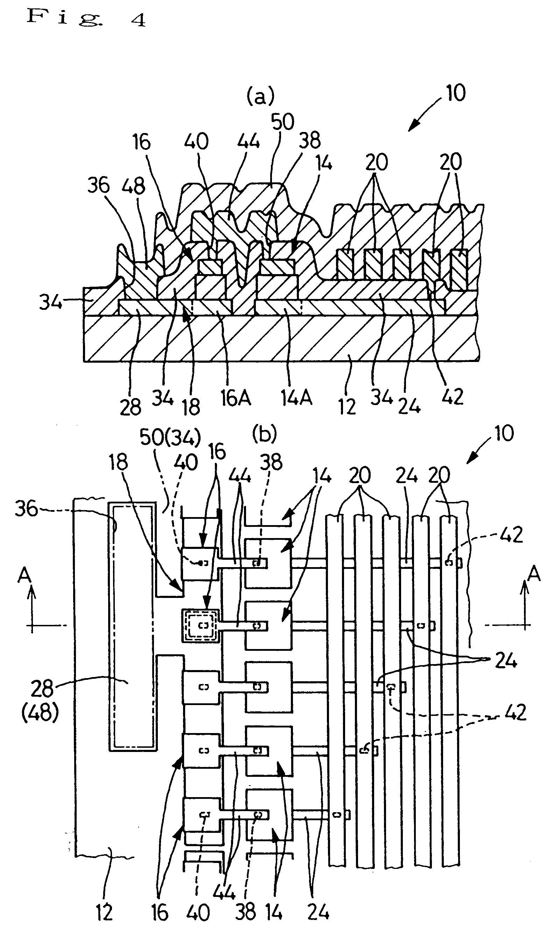

For example, while in the above embodiment the insulating protective film 50 was formed over the entire area of the glass substrate 12 and then etched to remove only its portion corresponding to the outer take-out electrode 48 as the electrode pad 28, it is possible as well to etch a marginal portion of the protective film 50 inclusive of the portion corresponding to the electrode pad 28 while leaving the semiconductor element sections 14 and 16 and matrix lead section 20 covered as shown in Fig. 4. In this case, in the marginal area, from which the insulating protective film 50 has been removed, the outer take-out electrode 48 of a metal and the inter-layer insulating film 34 are formed, and thus there is substantially no possibility of the exposure of the surface of the glass substrate 12 (13) and etching of the same glass substrate.

In such Method of manufacture of the semiconductor device 10, no other portion of the inter-layer insulating film 34 than the portions corresponding to the contact sections 36, 38, 40 and 42 is etched to suppress sputtering of the component of the glass substrate 13, thus eliminating re-deposition of sputtered component. Thus, the outer take-out electrode 48, connection electrode 44 and matrix leads 20 formed on the inter-layer insulating film 34 are firmly connected to their respective inner electrodes. The semiconductor device 10 thus obtained is free from weakening of the adhesion and increase of the connection resistance of the outer take-out electrode 48 and thus has stable electric performance and excellent wire bonding property.

Using the above embodiment of the method, many samples of the semiconductor device 10 having the configuration shown in Fig. 4 were produced, and of randomly taken-out 100 of these samples the number of samples having recognized open bit defect and the number of samples found to be defective after wire bonding test were checked. The bit defect was recognized in two of the 100 samples, and there was no defective sample recognized after the wire bonding test. For comparison, many samples of the semiconductor device shown in Fig. 9 were produced by the prior art method of manufacture, and randomly taken-out 100 of these samples are checked likewise. In this case, the bit defect was recognized in 21 among the 100 samples, and 12 among the 100 samples were defective as found after the wire bonding test.

It will be appreciated from the above that sufficient effects are obtainable by covering the substrate area other than the contact sections for connection to external parts with the inter-layer insulating film 34.

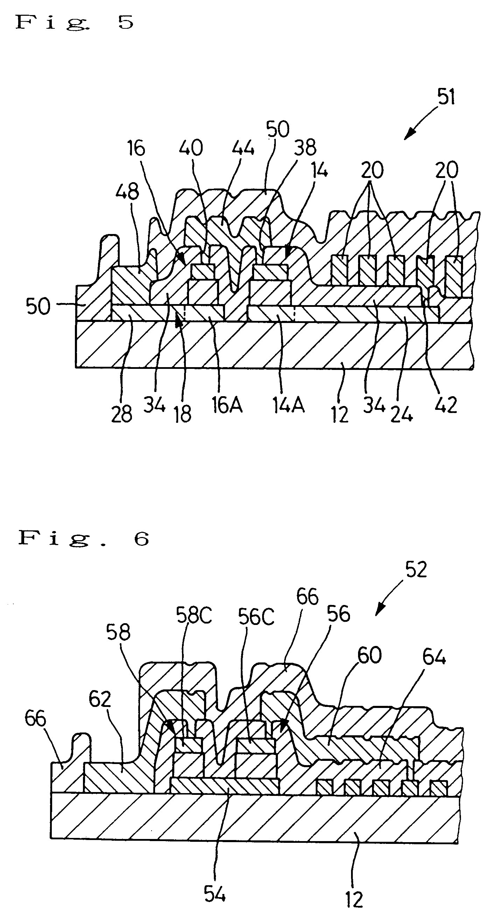

Fig. 5 shows a further embodiment of the semiconductor device 51, in which inter-layer insulating film 34 is removed for an edge portion of the glass substrate 12 inclusive of the electrode pad 28. In this embodiment, insulating protective film 50 covers a marginal portion of outer take-out electrode 48 formed on the electrode pad 28, that is, it covers the entire area of the glass substrate 12 except for the electrode pad 28. With this insulating protective film 50 it is possible to ensure moisture resistance of the semiconductor device 51, thus eliminating the corrosion of the electrode pad 28 and leaks and electrode corrosion in the semiconductor element sections 14 and 16.

Fig. 6 shows a further embodiment of the semiconductor device 52. In this instance, inner electrode 54 formed on glass substrate 12 constitutes a connection electrode for opposite polarity series connection of photo- and blocking diodes 56 and 58, and lead electrode 60 and outer take-out electrode 62 are provided on respective outer electrodes 56C and 58C via inter-layer insulating film 64. In this form of semiconductor device 52, the inter-layer insulating film 64 is removed for an edge portion of the glass substrate 12, and the outer take-out electrode 62 is formed directly on the glass substrate 12. In this embodiment of the semiconductor device 52, therefore, the insulating protective film 66 covers the entire area of the glass substrate 12 except for the electrode pad constituted by the outer take-out electrode 62 and thus ensures the moisture resistance.

While in the above instance of Fig. 6 the outer take-out electrode 62 was formed on the glass substrate 12 with the surface thereof damaged by etching as in the prior art, as in a further embodiment of the semiconductor device 68 shown in Fig. 7, outer take-out electrode 62 may be formed on inter-layer insulating film 64. In this semiconductor device 68, moisture resistance is ensured by the inter-layer insulating film 64 and insulating protective film 66. With this embodiment, leaks and corrosion can be eliminated, satisfactory wire bonding property of the outer take-out electrode 62 can be obtained, and electric connection via contact holes can be obtained with less connection resistance.

Fig. 8 shows a further embodiment of the semiconductor device 70. In this instance, outer take-out electrode 62 is formed on inter-layer insulating film 64 covering glass substrate 12. The insulating protective film 66 need to cover semiconductor element sections 56 and 58 and matrix lead section and may be removed for an edge portion inclusive of the outer take-out electrode 62. Again with this embodiment, it is possible to obtain satisfactory wire bonding property of the outer take-out electrode 62 and obtain electric connection via the contact holes with less connection resistance.

The above embodiments of the invention have concerned with semiconductor devices comprising two semiconductor elements, i.e., a photo-diode and a blocking diode, but this is by no means limitative, and the invention is of course applicable as well to a semiconductor device comprising a single semiconductor element. Further, the semiconductor layer is not limited to the pin-type amorphous silicon type semiconductor layer, and it is possible to use as well semiconductor layers obtained from non-crystalline or fine crystals of amorphous silicon type semiconductors, e.g., amorphous silicon a-Si, hydrogenated amorphous silicon a-Si:H, hydrogenated amorphous silicon carbide a-SIC:H, amorphous silicon nitride, etc. and alloys of silicon and other elements such as carbon, germanium and tin in pin-, nip-, ni-, pn-, MIS-, heretojunction, homo-junction and Shottkey barrier types and combinations of these types. Further, the invention is applicable to semiconductor devices comprising other than the amorphous silicon type as well, for instance those comprising GaAS and CdS type semiconductor elements.

Further, the insulating substrate is not limited to glass substrates, and it is possible to use as well metal substrates clad with such insulators as oxides, nitrides and oxynarides of silicon. Further, the material of the inner electrode may be titanium, nickel, etc. as well as chromium. Further, the material of the inter-layer insulating film may be oxides, nitrides, oxynarides of silicon. These are by no means limitative.

Further, the inter-layer insulating film is most suitably patterned by the reactive ion etching process or like dry etching process, but it is of course possible, if necessary, to use a wet etching process. Moreover, various other changes, modifications and improvements are possible by the person having ordinary knowledge in the art without departing from the spirit and scope of the invention.

The invention concerns a semiconductor device, which comprises an insulating substrate, semiconductor elements, electrodes connected thereto via an inter-layer insulating film and an insulating protective film, permits semiconductor element sections and electrode sections to be free from leaks and electrode to be free from corrosion and connection resistance to have stable even under high temperature, high relative humidity conditions and ensures enhanced electrode adhesion to provide for improved wire bonding performance, and also a method of manufacturing the same.

An inter-layer insulating film 34 covering an insulating substrate 12 is etched to remove only its portions corresponding to contact sections 36, 38, 40 and 42 necessary for connection to external parts. An insulating protective film 50 covering the insulating film 12 is etched to remove only electrode pad sections 28 necessary for connection to external parts. The inter-layer insulating film 34 and/or insulating protective film 50 are patterned such as to cover a marginal portion of electrode pad sections 28.

**Claims**

1. A semiconductor device comprising an insulating substrate, a semiconductor element formed on said insulating substrate and constituted by a lamination of an inner electrode, a semiconductor layer and an outer electrode, an inter-layer insulating film covering at least said semiconductor element and a connection electrode provided via said inter-layer insulating film, said inter-layer insulating film being formed on the entire area of said insulating substrate except for contact sections for connection to external parts.

2. The semiconductor device according to claim 1, wherein said contact sections include an electrode pad section contiguous to said lower electrode of said semiconductor element, said electrode pad section having at least a marginal portion covered by said inter-layer insulating film.

3. A semiconductor device comprising an insulating substrate, a semiconductor element formed on said insulating substrate and constituted by a lamination of an inner electrode, a semiconductor layer and outer electrode an inter-layer insulating film covering at least said semiconductor element, a connection electrode provided via said inter-layer insulating film and an insulating protective film covering the constituent elements on said insulating substrate, said insulating protective film being formed over the entire area of said insulating substrate except for a signal input/output electrode pad section.

4. The semiconductor device according to claim 3, wherein said inter-layer insulating film is formed on the entire area of said insulating substrate except for contact sections for connection to external parts.

5. The semiconductor device according to one of claims 3 and 4, wherein said signal input/output electrode pad section has at least a marginal portion covered by said insulating protective film.

6. The semiconductor device according to one of claims 4 and 5, wherein said contact sections include an electrode pad section contiguous to said lower electrode of said semiconductor element, said electrode pad section having at least a marginal portion covered by said inter-layer insulating film.

7. A method of manufacturing a semiconductor device, which comprises an insulating substrate, a semiconductor element formed on said substrate and constituted by a lamination of an inner electrode, a semiconductor layer and an outer electrode, an inter-layer insulating film covering at least said semiconductor element and a connection electrode provided via said inter-layer insulating film, said method comprising covering the entire area of said insulating substrate with said inter-layer insulating film and removing portions of said inter-layer insulating film corresponding to said contact sections for connection to external parts.

8. A method of manufacturing a semiconductor device, which comprises an insulating substrate, a semiconductor element formed on said insulating substrate and constituted by a lamination of an inner electrode, a semiconductor layer and an outer electrode, an inter-layer insulating film covering at least said semiconductor element, a connection electrode provided via said inter-layer insulating film and an insulating protective film covering the constituent elements on said insulating substrate, said method comprising covering the entire area of said insulating substrate with said insulating protective film and then removing a portion of said insulating protective film corresponding to said signal input/output electrode pad section.

9. The method of manufacturing a semiconductor device according to claim 8, wherein after covering the entire area of said insulating substrate with said inter-layer insulating film portions of said inter-layer insulating film corresponding to said contact sections for connection to external parts are removed.

# Fig 1

(a)

(b)

Fig. 2

(a)

22

13(12)

(b)

28  18  16A        14A        24

13

(c)

18                        30

28    16A  14A  13    24

(d)

32  30

28  18  16A  14A  13        24

F i g. 3

(a)

16C    14C    30

28    16A    14A    13    24

(b)

16    16C    14C    14
16B    14B
28    24
16A    14A    13

(c)

36    16    40    38    14    34  42
28    18  16A    14A    13    24

44 (d)
48  34    40    38  34    20    20
34
28    18    16A  14A  13    24

Fig. 4

(a)

(b)

Fig. 5

Fig. 6

Fig. 7

Fig. 8

Fig. 9

(a)

(b)

Fig. 10

116

114

124

114

Fig. 11

120

122

120 114

Fig. 12

(a)

(b)

(c)

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | PATENT ABSTRACTS OF JAPAN<br>vol. 11, no. 88 (E-490)(2535) 18 March 1987<br>& JP-A-61 242 068 ( MATSUSHITA ELECTRONICS CORP. ) | 1,2 | H01L27/146 |
| Y | * abstract * | 3-6 | |
| A | | 7-9 | |
| | --- | | |
| Y | US-A-4 499 384 (SEGAWA ET AL.) | 3-6 | |
| A | * column 5, line 15 - line 35; figure 3 *<br>* abstract * | 1,2,7-9 | |
| | --- | | |
| A | US-A-4 764 682 (SWARTZ)<br>* column 9, line 31 - line 40 *<br>* column 9, line 55 - line 65; figure 8 *<br>* abstract * | 1-9 | |
| | --- | | |
| A | US-A-5 004 903 (KITAMURA ET AL.)<br>* column 2, line 31 - line 48 *<br>* abstract * | 1-9 | |
| | --- | | |
| P,A | EP-A-0 446 861 (NIPPON STEEL CORPORATION)<br>* column 8, line 32 - line 35 *<br>* column 8, line 48 - line 58; figure 2 * | 1-9 | TECHNICAL FIELDS SEARCHED (Int. Cl.5 )<br><br>H01L |
| | ----- | | |

The present search report has been drawn up for all claims

| Place of search | Date of completion of the search | Examiner |
|---|---|---|
| THE HAGUE | 27 JULY 1992 | ONSHAGE A.C. |